# EUROPEAN PATENT APPLICATION

(11) **EP 4 270 493 A1**
(43) Date of publication of application: **01.11.2023**
(21) Application number: 22882259.9
(22) Date of filing: 28.04.2022
(51) Int. Cl.: H01L 31/0224, H01L 31/068, H01L 31/18, H01L 21/288

(54) **CRYSTALLINE SILICON SOLAR CELL AND METALLIZATION METHOD THEREFOR**

(30) Priority: 19.10.2021 CN 202111216439
(71) Applicant: Tongwei Solar (Chengdu) Co., Ltd., Chengdu, Sichuan 610299 (CN)
(72) Inventor: SU, Rong, Chengdu, Sichuan 610299 (CN); XING, Guoqiang, Chengdu, Sichuan 610299 (CN); XIAO, Shengyi, Chengdu, Sichuan 610299 (CN); LIU, Zhengxin, Chengdu, Sichuan 610299 (CN)
(74) Representative: Marks & Clerk LLP
(86) International application number: PCT/CN2022/089984
(87) International publication number: WO 2023/065634

(57) **Abstract**

A crystalline silicon solar cell and a metallization method therefor, which belong to the field of solar cells. The crystalline silicon solar cell comprises a photovoltaic structure, and passivation mechanisms, which are respectively formed on the front face and back face of the photovoltaic structure, wherein the front face is also provided with a front-face electrode, which is electroplated by using a conductive layer that is formed by means of chemical plating, the back face is also provided with a back-face electrode, which is electroplated by using another conductive layer that is formed by means of chemical plating, and a heavily doped area is formed in a region of the back face that corresponds to the back-face electrode. The cell has low manufacturing costs, high conversion efficiency and high reliability.

## Description

### CROSS-REFERENCE TO RELATED APPLICATIONS

This application claims priority of Chinese Patent Application No. 2021112164394, filed on October 19, 2021, entitled "CRYSTALLINE SILICON SOLAR CELL AND METALLIZATION METHOD THEREFOR", the entire content of which is incorporated herein in its entirety.

### TECHNICAL FIELD

The present disclosure relates to the field of solar cells, in particular to a crystalline silicon solar cell and a metallization method thereof.

### BACKGROUND

As a green and environmentally friendly energy technology, crystalline silicon solar cells have developed rapidly in recent years, and various new crystalline silicon technologies have emerged in an endless stream. Currently, passivated emitter and rear contact (PERC) solar cells are the mainstay in the market, and the mainstream mass production efficiency has exceeded 23.3%. However, in the conventional process of preparing PERC solar cells, the cost of screen printing to prepare Ag electrodes has approached the extreme, and it is difficult to make a breakthrough. Moreover, the width and height of the grid line of the Ag electrode prepared by screen-printing process fluctuate greatly, and which is prone to printing offset, slurry leakage, broken grid, false printing, etc.

### SUMMARY

The present disclosure provides a crystalline silicon solar cell and metallization method thereof, which can address the problems occurring in screen printing silver electrodes.

A crystalline silicon solar cell includes P-type silicon substrate provided with an N+ emitter on a front side thereof to form a photovoltaic structure, a front passivation structure formed on the emitter, a rear passivation structure formed on a rear side of the silicon substrate, a front electrode, and a rear electrode. The front passivation structure is provided with a front groove extending into the N+ emitter. The rear passivation structure is provided with a rear groove extending into the silicon substrate. The front electrode is filled in the front groove, the front electrode includes a front contact electrode and an electroplated front lead-out electrode, and the front lead-out electrode is in contact with the emitter through the front contact electrode. The rear electrode is filled in the rear groove, the rear electrode includes a rear contact electrode and an electroplated rear lead-out electrode, the rear lead-out electrode is in contact with the silicon substrate through the rear contact electrode, and a region of the silicon substrate in contact with the rear contact electrode forms a P+ doped region.

According to some embodiments of the present disclosure, the emitter is formed with an N++ doped region corresponding to a position where the front electrode is in contact with the emitter.

According to some embodiments of the present disclosure, the front contact electrode and the rear contact electrode are independently selected from the group consisting of titanium, gold, silver, nickel, and platinum, the front lead-out electrode and the rear lead-out electrode are independently selected from the group consisting of gold, platinum, copper, and silver; or the front lead-out electrode and the rear lead-out electrode are independently selected from an alloy composed of two or more elements of gold, platinum and silver, or a tin-silver alloy.

According to some embodiments of the present disclosure, thicknesses of the front contact electrode and the rear contact electrode are independently controlled to be less than 5 microns, and thicknesses of the front lead-out electrode and the rear lead-out electrode are independently controlled to be 5 to 20 microns.

According to some embodiments of the present disclosure, the front lead-out electrode is an electroplated copper electrode, the rear lead-out electrode is an electroplated copper electrode, the front contact electrode is an electroless nickel-plated electrode, and the rear contact electrode is an electroless nickel-plated electrode.

According to some embodiments of the present disclosure, the front passivation structure includes a front passivation layer and a front anti-reflection layer stacked sequentially from the emitter; and/ or, the rear passivation structure includes a rear passivation layer and a rear anti-reflection layer stacked sequentially from the rear side of the silicon substrate.

According to some embodiments of the present disclosure, the front passivation layer is a silicon dioxide layer, the front anti-reflection layer is nitridosilicates, the rear passivation layer is aluminum oxide, and the rear anti-reflection layer is nitridosilicates.

According to some embodiments of the present disclosure, the crystalline silicon solar cell further includes electrode protective layers attached to the front electrode and the rear electrode, respectively.

According to some embodiments of the present disclosure, the electrode protective layer is made by electroless tin plating or electrolytic tin plating.

According to some embodiments of the present disclosure, a front covering layer is provided on the front passivation structure, a rear covering layer is provided on the rear passivation structure, and the front covering layer and the rear covering layer are provided with through grooves distributed along a thickness direction of the cell, respectively.

According to an embodiment of the present disclosure, a metallization method for manufacturing an electrode of a crystalline silicon solar cell includes providing a substrate for a crystalline silicon solar cell without electrodes, performing a front side patterning to a front side of the substrate using a mask to form a front groove, and then forming a front bottom conductive layer on a bottom of the front groove by electroless plating, and electroplating a front electrode, and performing a rear side patterning to a rear side of the substrate using a mask to form a rear groove, performing heavy doping, and then forming a rear bottom conductive layer in the rear groove by electroless plating, and electroplating a rear electrode.

According to some embodiments of the present disclosure, the rear side patterning and heavy doping are performed simultaneously.

According to some embodiments of the present disclosure, a method of performing the rear side patterning to the rear side of the substrate using the mask to form the rear groove and performing heavy doping includes covering the rear side of the substrate with a covering material film as the mask, performing laser grooving and laser heavy doping using the material film as a doping source.

According to some embodiments of the present disclosure, the rear side patterning and heavy doping are performed in steps.

According to some embodiments of the present disclosure, the method of performing the rear side patterning to the rear side of the substrate using the mask to form the rear groove and performing heavy doping includes covering the rear side of the substrate with a covering material film containing no dopant source as a mask, performing laser grooving, and then introducing the dopant source to perform heavy doping by ion implantation.

According to some embodiments of the present disclosure, after performing the front side patterning to the front side of the substrate using the mask, and prior to electroless plating the front bottom conductive layer, and electroplating the front electrode, the metallization method further includes performing heavy doping to a region of the emitter in the substrate corresponding to the front side patterning to form an N++ doped region.

According to some embodiments of the present disclosure, the metallization method further includes a step of protecting the front electrode and the rear electrode, and the step of protecting includes covering a surface of the front electrode and a surface of the rear electrode with a protective layer.

According to some embodiments of the present disclosure, the protective layer covers the electrode surface by immersing the electrode in a solution; or, the protective layer covers the electrode surface by electroless plating or electroplating.

In the above implementation process, the metallization of crystalline silicon solar cell provided by the embodiments of the present disclosure uses electroplating instead of screen printing to manufacture the electrodes, so that problems such as offset, slurry leakage, broken grids, and false printing that occur in printing can be avoided. Moreover, an annealing process after printing is not required, thereby helping to improve the consistency of the height and width of the electrodes, etc.

### BRIEF DESCRIPTION OF THE DRAWINGS

In order to illustrate the embodiments of the present disclosure more clearly, the drawings used in the embodiments will be described briefly. Apparently, the following described drawings are merely for the embodiments of the present disclosure, and other drawings can be derived by those of ordinary skill in the art without any creative effort.
FIG. 1 is a schematic view of a crystalline silicon solar cell according to an embodiment of the present disclosure.
FIG. 2 shows a schematic view of a PERC crystalline silicon solar cell with screen-printed silver electrodes.
FIG. 3 is a flowchart of a preparation process of a crystalline silicon solar cell according to an embodiment of the present disclosure.
FIG. 4 is a flowchart of a preparation process of a crystalline silicon solar cell according to another embodiment of the present disclosure.
FIG. 5 is a schematic view of a doping method formed in a preparation process of a crystalline silicon solar cell according to an embodiment of the present disclosure.
FIG. 6 is a schematic view of a doping method formed in a preparation process of a crystalline silicon solar cell according to another embodiment of the present disclosure.

### DETAILED DESCRIPTION OF THE EMBODIMENTS

In view of the problem existing in screen-printing method used in the metallization process of PERC cells, in the present disclosure, the inventors provide a solution to effectively avoid the aforementioned problem.

In general, in the embodiments of the present disclosure, electrodes are prepared by an electroplating process. Through the optimization of the solution, a low-cost, stable and uniform height-to width ratio electrodes can be achieved, so that the preparation cost of a PERC crystalline silicon solar cell can be greatly reduced and the conversion efficiency and reliability of a solar cell can be improved.

In the embodiment, in the process of metallizing to preparing an electrode after most of the crystalline silicon solar cell has been completed, patterning (grooving) is performed first, then a conductive structure is deposited in a groove, and then the conductive structure is connected to a power source for electroplating, in order to make electrodes in the groove.

In addition, in practice, the inventors have found that the method of firstly grooving and then electroplating tends to cause the electroplating material to be located outside an area of the groove, so that a surface of the prepared electrode forms a mushroom head-shaped structure. Therefore, in the embodiment, the surface of the cell is covered with a mask before patterning. After the groove is formed by patterning, the conductive structure is deposited, and then electroplating is performed by sequentially electrifying, so as to achieve the preparing of electroplated electrode. After that, the mask is removed to obtain electroplated electrodes with precise, consistent and stable structure.

Through such the electroplating solution for metallization and preparing of electrode, more precise control of the height-to width ratio of electrode can be achieved, and problems such as broken grid and false printing can be avoided.

Based on the above solutions, a crystalline silicon solar cell is provided.

The improvement of the battery is at least that the related screen-printed silver electrode is replaced by a copper electrode prepared by electroplating. Since copper is less expensive relative to silver, the solution of the present disclosure reduces the cost. Meanwhile, the electroplating process is also easy to implement, and the process parameters are easy to be controlled, which is also beneficial to reduce the cost. In addition, compared with the screen-printed silver electrode, the height-to-width ratio of the electroplated electrode can be more precisely controlled, and the effect of improving the conversion efficiency and reliability of the cell can also be achieved by optimizing the solution for preparing the electroplated copper electrode. Moreover, the process consistency of the electroplated electrode is good, and the stability and uniformity of the electroplated electrode can also be improved, thereby improving the stability and consistency of different batches of cells.

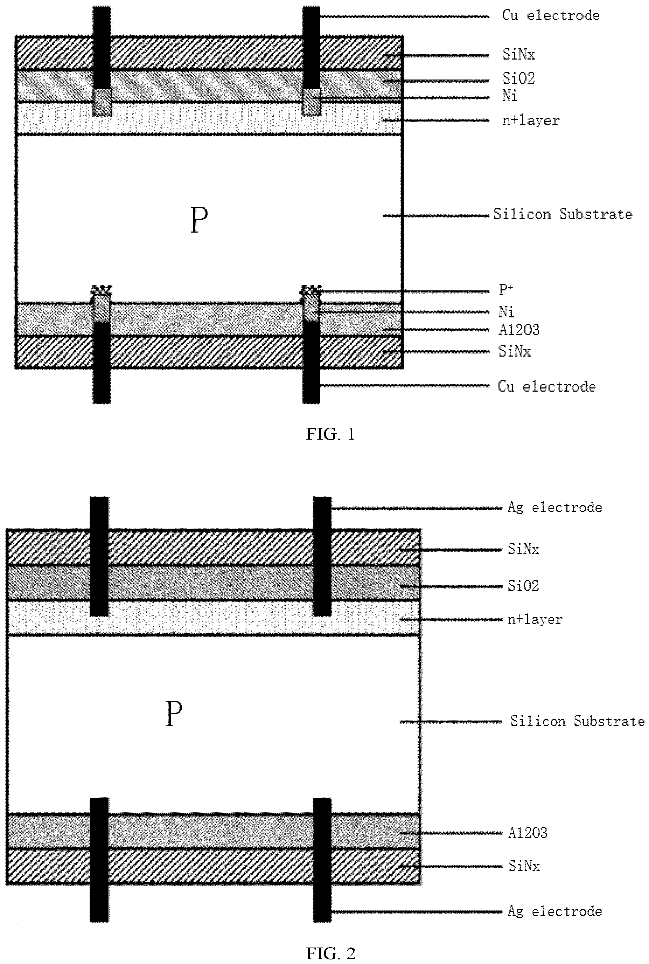

In the embodiment, the crystalline silicon solar cell is a passivated emitter and rear contact (PERC) type of crystalline silicon solar cell, the structure of which is shown in FIG. 1.

The PERC cell is a crystalline silicon solar cell, which uses P-type silicon as a base, and uses an N+ doped layer formed on a front side as an emitter, so as to form a photovoltaic structure of PN junction.

Based on the requirement of passivation, a front passivation structure is made on the front side of the emitter, and the front passivation structure is provided with a front groove. The front groove extends from the surface side of the front passivation structure into the N+ emitter along a thickness direction of the cell (does not extend through the N+ emitter). The front passivation structure includes a silicon dioxide layer and a silicon nitride layer. Also, the silicon dioxide layer is located between the silicon nitride and the N+ emitter. The silicon dioxide can play a role of passivation, and the silicon nitride may be used as an insulating layer, a protective layer, and an anti-reflection layer.

Meanwhile, a rear passivation structure is formed on a rear side of the silicon substrate. In addition, as similar to the front passivation structure, the rear passivation structure has a rear groove. Also, the rear groove extends from a surface of the rear passivation structure into the silicon substrate along the thickness direction of the cell. The rear passivation structure includes an aluminum oxide layer and a silicon nitride layer. Also, the aluminum oxide layer is located between the silicon nitride and the silicon substrate. The aluminum oxide layer can play a role of passivation, and the silicon nitride can be used as an insulating layer, a protective layer, and an anti-reflection layer.

The material of each layer in the above-mentioned front passivation structure and rear passivation structure is not limited to the embodiments described above, and other common materials in the art may be used.

As a structure for leading out current, a conductive structure is provided in the front groove and the rear groove. In an embodiment, the conductive structure includes a front electrode and a rear electrode.

The front electrode is filled in the front groove. The front electrode includes a front contact electrode (whose thickness may be controlled within 5 microns) and an electroplated front lead-out electrode (whose thickness may be controlled within 5 to 20 microns), and the front lead-out electrode is in contact with the emitter through the front contact electrode. In some other embodiments, localized heavy doping may be formed in a region where the front electrode (specifically the front contact electrode) contacts the N+ emitter, thereby forming an N++ doped region in the region, which may serve as a selective emitter. In this way, the part where the front electrode is in contact with the silicon base is heavily doped, while an area of the silicon base between the electrodes is lightly doped. Such a selective emitter can reduce recombination, improve photoresponse, and reduce contact resistance, so that short-circuit current, open-circuit voltage and fill factor can be improved, thereby improving conversion efficiency.

Correspondingly, the rear electrode is filled in the rear groove, and the rear electrode includes a rear contact electrode (whose thickness may be controlled within 5 microns) and an electroplated rear lead-out electrode (whose thickness may be controlled within 5 to 20 microns). The rear lead-out electrode is in contact with the silicon substrate through the rear contact electrode. In addition, as a good electrical contact region between the substrate and the rear electrode, a P+ doped region is formed in the region of the silicon substrate that is in contact with the rear contact electrode.

As an embodiment, the front contact electrode may include any of titanium, gold, silver, nickel, and platinum, while the front lead-out electrode includes gold, platinum, copper, or silver, or the front lead-out electrode may include an alloy composed of two or more elements of gold, platinum and silver, or a tin-silver alloy.

Similarly, the rear contact electrode may include titanium, gold, silver, nickel, platinum or any combination thereof, while the rear lead-out electrode may include gold, platinum, copper or silver, or the rear lead-out electrode may include an alloy composed of two or more elements of gold, platinum and silver, or a tin-silver alloy.

In the illustrated structure of the present disclosure, the front lead-out electrode is an electroplated copper electrode made by electroplating, and the rear lead-out electrode is an electroplated copper electrode made by electroplating. The front contact electrode is an electroless nickel-plated electrode, and the rear contact electrode is an electroless nickel-plated electrode. Since the screen-printed Ag electrode is replaced by the Cu electrode prepared by electroplating, high-temperature baking and curing are not required, and good flatness and uniformity are achieved. The contact electrode of nickel material can be used as a conductive electrode when preparing the electroplated electrode. At the same time, due to the existence of the contact electrode, the ohmic contact of the lead-out electrode can be increased and the atoms of the lead-out electrode can be prevented from diffusing into the cell.

In addition, the wire resistance of the copper electrode is less than 0.452/cm, which is more advantageous than the silver electrode in terms of conductivity. In addition, the raw material cost of the Cu electrode is low, which can greatly reduce the electrode manufacturing cost of the PERC crystalline silicon solar cell. In addition, the electrode is prepared by electroplating, the height-to-width ratio of the grid line can be strictly controlled, and the thinner grid line can effectively increase the light-receiving area of the cell, thereby improving the conversion efficiency and reliability of the solar cell.

In addition, considering the durability and stability of the electrode, the crystalline silicon solar cell in some embodiments include electrode protective layers. The front electrode and the rear electrode are covered by the electrode protective layers, respectively. The electrode protective layer can prevent the electrode such as the lead-out electrode from being oxidized. As an embodiment, the electrode of the crystalline silicon solar cell may be protected by immersing in metal protective agent. The metal protective agent includes but is not limited to chemical protective liquids such as copper protective agents or silver protective agents. Alternatively, in some embodiments, the protective layer is formed by performing electroless tin plating or electrolytic tin plating on the lead-out electrode. These protective layers can not only protect the lead-out electrode, but also be used for welding.

In addition, in some embodiments, a front covering layer is provided on the front side or front passivation structure of the cell, while a rear covering layer is also provided on the rear side or rear passivation structure of the cell. The thickness of the covering layer can be controlled to 5 to 100 microns. Moreover, the front covering layer and the rear covering layer are provided with through grooves distributed along the thickness direction of the cell, respectively. The through groove is used for the lead-out electrode to extend through. It should be noted that the covering layer is based on considerations such as the convenience and quality of the cell. These covering layers can be used as masks in the cell manufacturing process to improve the quality of the electroplated lead-out electrodes, so as to avoid covering other areas. That is, the covering layer is made first, and then, on the basis of the covering layer, the electrode is made to form the electroplated lead-out electrode. After the electrode is made, the covering layer is removed, so that the cell can receive light.

In practice, the production cost of the crystalline silicon solar cell based on the above structure in the embodiment of the present disclosure is improved. The cost of the Ag electrode of the PERC crystalline silicon solar cell is 8 cents/watt, and the cost of electroplating Cu is 5 cents/watt. In addition, due to the lower wire resistance of the copper electrode, the Ag electrode wire resistance is 0.98Ω/cm, and the Cu electrode wire resistance is 0.39Ω/cm. Moreover, electroplating can strictly control the width and height of the grid lines and reduce the width of the grid lines, thus the light-receiving area of the cell can be increased, thereby the conversion efficiency of the cell can be improved, as shown in table 1 below.

**Table 1: Comparison of cell performance**

| Group | V_{oc} (mV) | J_{sc} (A) | FF (%) | E_{ff} (%) |
|---|---|---|---|---|
| Compared PERC cell | 684.6 | 41.1 | 83 | 23.35 |
| PERC cell of the present disclosure | 687.3 | 41.3 | 83.1 | 23.62 |

The difference between the two cells in the above table 1 lies in the electrode structure. Among them, the electrode of the compared PERC cell is the screen-printed silver electrodes (see FIG. 2), while the electrode of the PERC cell of the present disclosure is the electroless nickel-plated contact electrode and electroplated copper lead-out electrode (see FIG. 1).

In order to facilitate those skilled in the art to implement the solution of the cell more conveniently, a metallization method is also provided according to an embodiment, which is used to prepare electrodes of crystalline silicon solar cells.

The metallization method includes the following steps.

Step 1, a substrate for a crystalline silicon solar cell without electrodes is provided.

Referring to the aforementioned PERC cell, the substrate in the metallization method includes a photovoltaic structure composed of a silicon substrate and a doped layer, that is, a PN junction, as well as a front passivation structure and a rear passivation structure. The substrate can be prepared using conventional equipment and processes for solar cells in the art, which will not be described in detail herein.

Step 2, a front side patterning is performed to a front side of the substrate using a mask to form a front groove, and then a front bottom conductive layer is formed on a bottom of the front groove by electroless plating, and a front electrode is electroplated.

The mask may be used as a protective layer, and a layer of protective film material is covered on the front side of the substrate, and then laser is used to form a groove until the N+ emitter layer is reached. Further according to the requirements of the structure and process, the N+ emitter layer may also be partially doped after forming the groove, so as to form the N++ layer. The doping method is, for example, ion beam implantation.

Step 3, a rear side patterning is performed to a rear side of the substrate using a mask to form a rear groove, heavy doping is performed, and then a rear bottom conductive layer is formed in the rear groove and a rear electrode is electroplated.

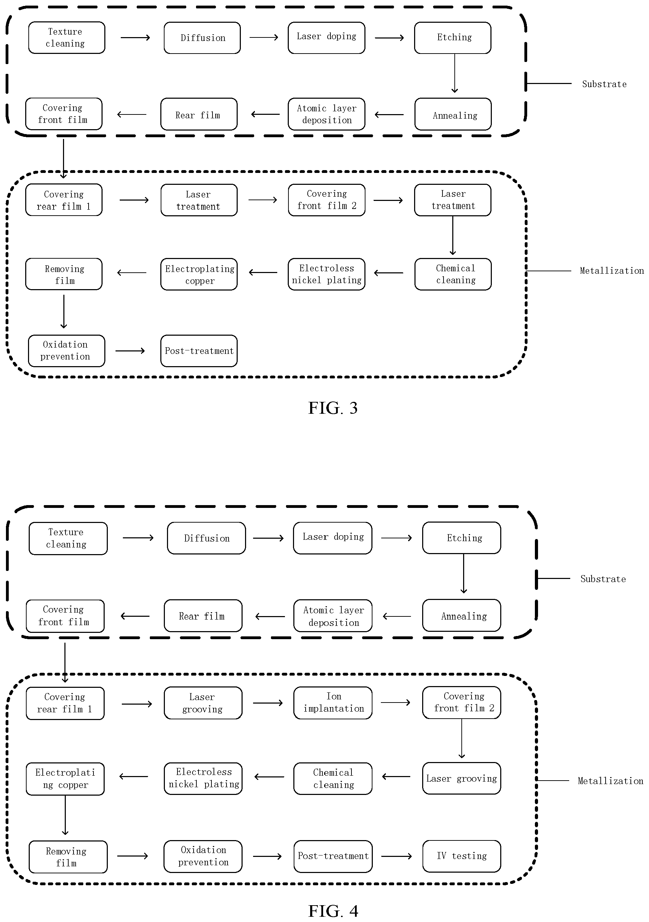

In some embodiments, the rear side patterning and heavy doping are performed simultaneously. For example, a method of performing the rear side patterning to the rear side of the substrate using the mask to form the rear groove and performing heavy doping includes covering the rear side of the substrate with a covering material film as the mask, performing laser grooving and laser heavy doping using the material film as a doping source. For example, the film material doped with boron source is covered on the front passivation structure, and then groove is provided by laser and the heavy doping is completed. The boron source is, for example, diborane (B₂H₆), borane (BH₄), boron trifluoride (BF₃), boron tribromide (BBr₃), boron trichloride (BC1₃) or other boron-containing substances. The metallization process implemented in this manner can be referred to as shown in FIG. 3. The chemical cleaning may be to use 15% HF to clean the residue in the patterned groove. The method to remove the covering material film is, for example, to use 10% sodium hydroxide (NₐOH) strong alkaline solution to remove the covering material film. A method of anti-oxidation is, for example, to immerse in copper protectant. Post-treatment can be done by annealing, electrical injection, light injection and other methods to improve cell performance.

Alternatively, in other embodiments, the rear side patterning and heavy doping are performed in steps. For example, the method of performing the rear side patterning to the rear side of the substrate using the mask to form the rear groove and performing heavy doping includes covering the rear side of the substrate with a covering material film containing no dopant source as a mask, performing laser grooving, and then introducing the dopant source to perform heavy doping by ion implantation. The metallization process implemented in this manner can be referred to as shown in FIG. 4.

Therefore, the difference between the rear side patterning and heavy doping performed simultaneously or in steps mainly lies in whether the material of the mask used contains elements for doping.

After the above processes are completed, the mask can be removed. The electroplated electrode can then also be protected. The step of protecting the front electrode and the rear electrode may be covering the surface of the front electrode and the surface of the rear electrode with a protective layer. Exemplarily, the protective layer is covered on the surface of the electrode by immersing the electrode in a solution, or, the protective layer is covered on the surface of the electrode by electroless plating or electroplating.

It should be noted that, in the above-mentioned process, the front bottom conductive layer, the electroplated front electrode, the rear bottom conductive layer, and the electroplated rear electrode in steps 2 and 3 can be made in the order described above. Alternatively, in other embodiments, grooves can be formed on the front side and the rear side of the substrate, respectively, and then the bottom conductive layer and electroplated electrode can be prepared. Alternatively, the front side is provided with grooves first, and the bottom conductive layer and the electroplated electrode are prepared in the front groove. Then, the rear side is provided with grooves, and the bottom conductive layer and the electroplated electrodes are prepared in the rear groove. Alternatively, the front side is provided with grooves, then the bottom conductive layer is prepared in the card, then the rear side is provided with grooves, the bottom conductive layer is prepared in the rear groove, and then the electroplated electrodes on the front and rear sides are prepared, respectively.

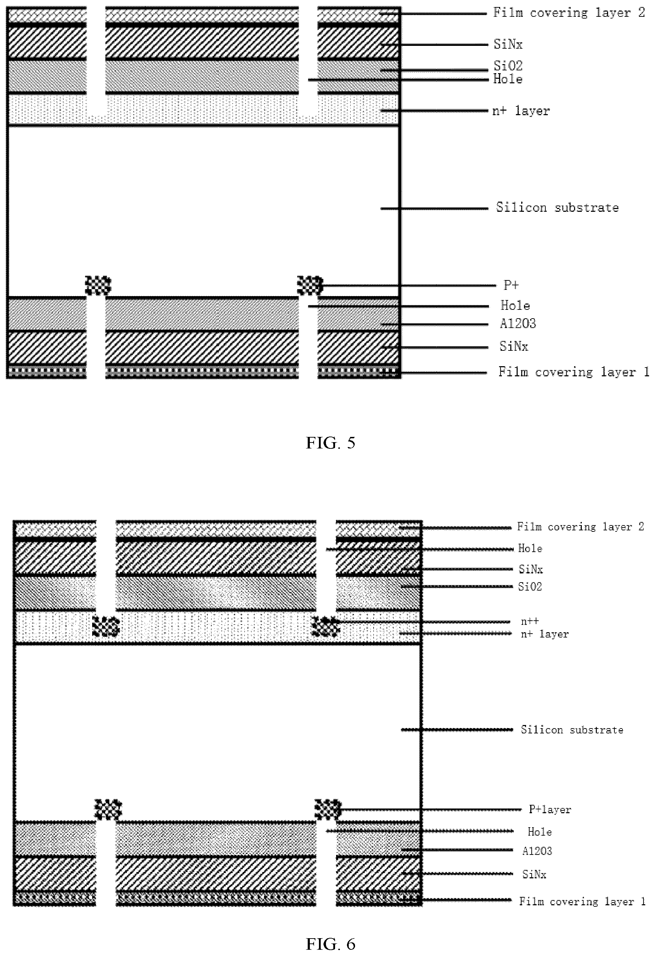

In other words, on the front side and the rear side of the substrate, the operation steps such as grooving, preparing the bottom conductive layer, preparing electroplated electrodes, and doping etc., can be optionally implemented, and the steps can be combined according to the required order, and are not limited to the steps described above. In some embodiments, during metallization, structures as shown in FIGS. 5 and 6 may be obtained. FIG. 5 and FIG. 6 mainly disclose the structure in which the substrate is covered with the mask and includes grooves.

The above descriptions are only preferred embodiments of the present disclosure, which are not intended to limit the present disclosure. For those skilled in the art, the present disclosure may have various variation and replacement. Any variations, equivalent replacements, improvements, etc. figured out within the technical scope disclosed in the present disclosure shall all fall within the protection scope of the present disclosure.

### Industrial applicability

The present disclosure provides the crystalline silicon solar cell and the metallization method thereof, which relates to the field of solar cells. The crystalline silicon solar cell includes the photovoltaic structure, passivation structures formed on the front and rear sides thereof, respectively. The front side of the crystalline silicon solar cell also has the front electrode electroplated with the conductive layer formed by electroless plating, and the rear side also has a rear electrode electroplated with the conductive layer formed by another electroless plating. The rear side forms a heavily doped region in a region corresponding to the rear electrode. The cell has low manufacturing cost, high conversion efficiency and reliability.

In addition, it should be understood that the disclosed crystalline silicon solar cells and the metallization method thereof are reproducible and can be applied in various industrial applications. For example, the crystalline silicon solar cell of the present disclosure can be applied to the field of solar cells.

## Claims

1. A crystalline silicon solar cell, comprising:
P-type silicon substrate provided with an N+ emitter on a front side thereof to form a photovoltaic structure;
a front passivation structure formed on the emitter, wherein the front passivation structure is provided with a front groove extending into the N+ emitter;
a rear passivation structure formed on a rear side of the silicon substrate, wherein the rear passivation structure is provided with a rear groove extending into the silicon substrate;
a front electrode filled in the front groove, wherein the front electrode comprises a front contact electrode and an electroplated front lead-out electrode, and the front lead-out electrode is in contact with the emitter through the front contact electrode; and
a rear electrode filled in the rear groove, wherein the rear electrode comprises a rear contact electrode and an electroplated rear lead-out electrode, the rear lead-out electrode is in contact with the silicon substrate through the rear contact electrode, and a region of the silicon substrate in contact with the rear contact electrode forms a P+ doped region.

2. The crystalline silicon solar cell according to claim 1, wherein the emitter is formed with an N++ doped region corresponding to a position where the front electrode is in contact with the emitter.

3. The crystalline silicon solar cell according to claim 1 or 2, wherein the front contact electrode and the rear contact electrode are independently selected from the group consisting of titanium, gold, silver, nickel, and platinum, the front lead-out electrode and the rear lead-out electrode are independently selected from the group consisting of gold, platinum, copper, and silver; or the front lead-out electrode and the rear lead-out electrode are independently selected from an alloy composed of two or more elements of gold, platinum and silver, or a tin-silver alloy;
optionally, thicknesses of the front contact electrode and the rear contact electrode are independently controlled to be less than 5 microns, and thicknesses of the front lead-out electrode and the rear lead-out electrode are independently controlled to be 5 to 20 microns;
optionally, the front lead-out electrode is an electroplated copper electrode, the rear lead-out electrode is an electroplated copper electrode, the front contact electrode is an electroless nickel-plated electrode, and the rear contact electrode is an electroless nickel-plated electrode.

4. The crystalline silicon solar cell according to any one of claims 1 to 3, wherein the front passivation structure comprises a front passivation layer and a front anti-reflection layer stacked sequentially from the emitter;
and/or, the rear passivation structure comprises a rear passivation layer and a rear anti-reflection layer stacked sequentially from the rear side of the silicon substrate;
optionally, the front passivation layer is a silicon dioxide layer, the front anti-reflection layer is nitridosilicates, the rear passivation layer is aluminum oxide, and the rear anti-reflection layer is nitridosilicates.

5. The crystalline silicon solar cell according to any one of claims 1 to 4, further comprising:
electrode protective layers attached to the front electrode and the rear electrode, respectively.

6. The crystalline silicon solar cell according to claim 5, wherein the electrode protective layer is made by electroless tin plating or electrolytic tin plating.

7. The crystalline silicon solar cell according to any one of claims 1 to 6, wherein a front covering layer is provided on the front passivation structure, a rear covering layer is provided on the rear passivation structure, and the front covering layer and the rear covering layer are provided with through grooves distributed along a thickness direction of the cell, respectively.

8. A metallization method for manufacturing an electrode of a crystalline silicon solar cell, the metallization method comprising:
providing a substrate for a crystalline silicon solar cell without electrodes;
performing a front side patterning to a front side of the substrate using a mask to form a front groove, and then forming a front bottom conductive layer on a bottom of the front groove by electroless plating, and electroplating a front electrode; and
performing a rear side patterning to a rear side of the substrate using a mask to form a rear groove, performing heavy doping, and then forming a rear bottom conductive layer in the rear groove by electroless plating, and electroplating a rear electrode.

9. The metallization method according to claim 8, wherein the rear side patterning and the heavy doping are performed simultaneously;
optionally, a method of performing the rear side patterning to the rear side of the substrate using the mask to form the rear groove and performing heavy doping comprises:
covering the rear side of the substrate with a covering material film as the mask, performing laser grooving and laser heavy doping using the material film as a doping source; or
the rear side patterning and heavy doping are performed in steps;
optionally, the method of performing the rear side patterning to the rear side of the substrate using the mask to form the rear groove and performing heavy doping comprises:
covering the rear side of the substrate with a covering material film containing no dopant source as a mask, performing laser grooving, and then introducing the dopant source to perform heavy doping by ion implantation.

10. The metallization method according to claim 8 or 9, wherein after performing the front side patterning to the front side of the substrate using the mask, and prior to electroless plating the front bottom conductive layer, and electroplating the front electrode, the metallization method further comprises:
performing heavy doping to a region of the emitter in the substrate corresponding to the front side patterning to form an N++ doped region.

11. The metallization method according to any one of claims 8 to 10, further comprising:
a step of protecting the front electrode and the rear electrode, wherein the step of protecting comprises: covering a surface of the front electrode and a surface of the rear electrode with a protective layer.

12. The metallization method according to claim 11, wherein the protective layer covers the electrode surface by immersing the electrode in a solution;
or, the protective layer covers the electrode surface by electroless plating or electroplating.
